# FASCICULE DE BREVET EUROPEEN

(11) **EP 2 742 821 B1**
(45) Date de publication et mention de la délivrance du brevet: **09.09.2015**
(21) Numéro de dépôt: 12197482.8
(22) Date de dépôt: 17.12.2012
(51) Int. Cl.: A44C 5/00, B29C 69/00, B29C 43/28, B29C 43/26, B29C 65/16, B29C 43/18, B29C 43/14, B29C 45/14, B29L 31/34, B29C 69/02

(54) **Procédé de fabrication d'un dispositif électronique portable flexible**
Herstellungsverfahren einer flexiblen tragbaren elektronischen Vorrichtung
Method for manufacturing a flexible portable electronic device

(43) Date de publication de la demande: 18.06.2014
(73) Titulaire: The Swatch Group Research and Development Ltd., 2074 Marin (CH)
(72) Inventeur: Heck, Pascal, 1196 Gland (CH); Nicolas, Cédric, 2000 Neuchâtel (CH)
(74) Mandataire: Supper, Marc

(56) Documents cités:
- GB-A- 1 491 532
- US-A- 3 562 037
- US-A- 4 682 415
- US-A1- 2007 022 602
- US-A1- 2011 051 569
- DATABASE WPI Week 200345 Thomson Scientific, London, GB; AN 2003-476444 XP002697233, -& JP 2003 164499 A (DAINIPPON PRINTING CO LTD) 10 juin 2003 (2003-06-10)

## Description

La présente invention concerne un procédé de fabrication d'un dispositif électronique portable flexible. Plus précisément, la présente invention concerne un procédé de fabrication en bande d'un tel dispositif électronique portable flexible.

La présente invention a pour objet la fabrication d'un dispositif électronique portable flexible capable au moins d'élaborer une information, ce dispositif électronique portable comprenant un corps souple agencé pour pouvoir être fixé à une partie d'un corps d'un utilisateur et un ensemble électronique pour élaborer l'information. Le corps du dispositif électronique portable est constitué d'une couche de matériau plastique tel qu'un élastomère qui confère au dispositif électronique portable une épaisseur et une résistance mécanique. Cette couche de matériau plastique est revêtue d'un premier film plastique imperméable, un second film plastique imperméable étant solidarisé sur un périmètre extérieur du premier film plastique imperméable. L'ensemble électronique pour élaborer l'information est disposé entre les premier et second films plastiques imperméables.

Pour réaliser un tel dispositif électronique portable flexible, un procédé de fabrication pièce à pièce consiste à effectuer les opérations suivantes :
- surmouler sur une face extérieure d'un premier film plastique imperméable une couche de matériau plastique souple qui constitue le corps du dispositif électronique portable ;
- monter l'ensemble électronique d'élaboration de l'information du côté de la face intérieure du premier film plastique imperméable, et
- solidariser un second film plastique imperméable sur le premier film plastique imperméable, de façon à délimiter entre les premier et second films plastiques imperméables une enceinte étanche dans laquelle est logé l'ensemble électronique d'élaboration de l'information.

Le cas échéant, le procédé peut comprendre une étape supplémentaire qui consiste, avant surmoulage du premier film plastique imperméable, à former à chaud le premier film plastique imperméable pour donner au premier film plastique imperméable un profil recherché.

Un tel procédé de fabrication pièce à pièce est adapté pour des productions en petites séries, typiquement pour la fabrication de prototypes qui permettent de valider le concept. On comprendra cependant qu'un tel procédé de fabrication pièce à pièce n'est pas envisageable pour une production de masse.

La présente invention a pour but de répondre à ces besoins en procurant un procédé de fabrication en série de dispositifs électroniques portables flexibles, ce procédé de fabrication présentant notamment un grand degré de liberté dans le choix des formes, de l'épaisseur et de la décoration des dispositifs électroniques portables.

A cet effet, la présente invention concerne un procédé de fabrication en série d'un dispositif électronique portable flexible capable au moins d'élaborer une information, ce dispositif électronique portable comprenant un ensemble électronique d'élaboration de l'information, le procédé comprenant les étapes consistant à faire défiler une première bande plastique imperméable devant un poste de surmoulage dans lequel la première bande plastique imperméable est surmoulée au moyen d'un matériau plastique souple qui donnera aux dispositifs électroniques portables flexibles résultants une épaisseur et une résistance mécanique,
le procédé comprenant en outre les étapes consistant à faire défiler une seconde bande plastique imperméable avec une face inférieure tournée vers le haut, successivement :
- devant un poste d'impression dans lequel la seconde bande plastique imperméable reçoit sur la face inférieure au moins une encre décorative ;
- devant un poste d'assemblage dans lequel la seconde bande plastique imperméable reçoit, de place en place, sur la face inférieure les ensembles électroniques d'élaboration de l'information,
le procédé comprenant enfin l'étape consistant à réunir et à solidariser la première bande plastique imperméable surmoulée avec la seconde bande plastique imperméable décorée, puis à libérer les dispositifs électroniques portables flexibles par découpe.

Grâce à ces caractéristiques, la présente invention procure un procédé de fabrication en bande d'un dispositif électronique portable flexible dans lequel il est possible, en utilisant une seule et même ligne de fabrication, de décliner les dispositifs électroniques portables selon différentes formes, épaisseurs, matières du corps souple et décorations. Il est même envisageable d'adapter les modèles de dispositifs électroniques portables en temps réel, voire en ligne par l'intervention de l'acheteur.

Selon une caractéristique complémentaire de l'invention, le procédé de fabrication comprend l'étape consistant, avant l'étape initiale de surmoulage de la première bande plastique imperméable, à faire défiler la première bande plastique imperméable devant un poste de formage à chaud pour ménager de place en place dans la première bande plastique imperméable une pluralité de logements destinés à recevoir chacun ultérieurement au moins un composant interne au dispositif électronique portable flexible.

D'autres caractéristiques et avantages de la présente invention ressortiront plus clairement de la description détaillée qui suit d'un mode de mise en oeuvre du procédé de fabrication selon l'invention, cet exemple étant donné à titre purement illustratif et non limitatif seulement en liaison avec le dessin annexé sur lequel :

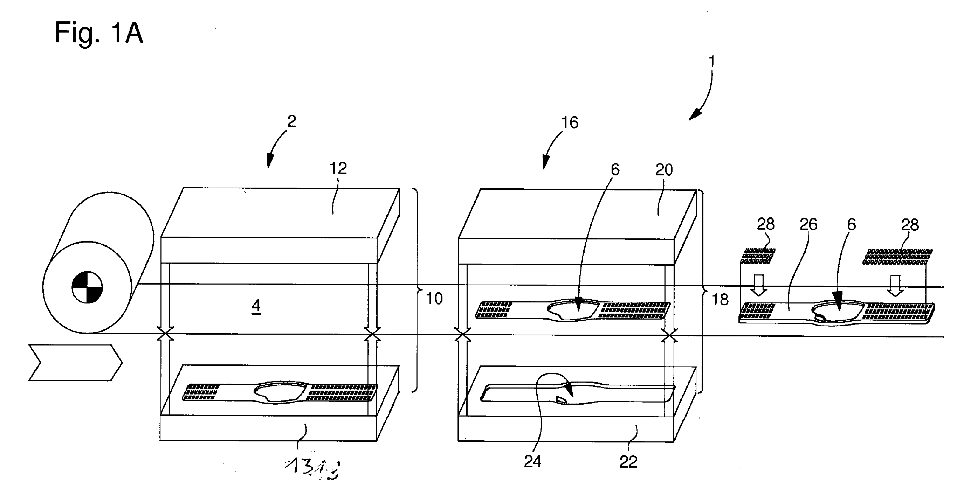

- la figure 1A est une représentation schématique de la partie de gauche d'une installation pour la mise en oeuvre du procédé de l'invention, et

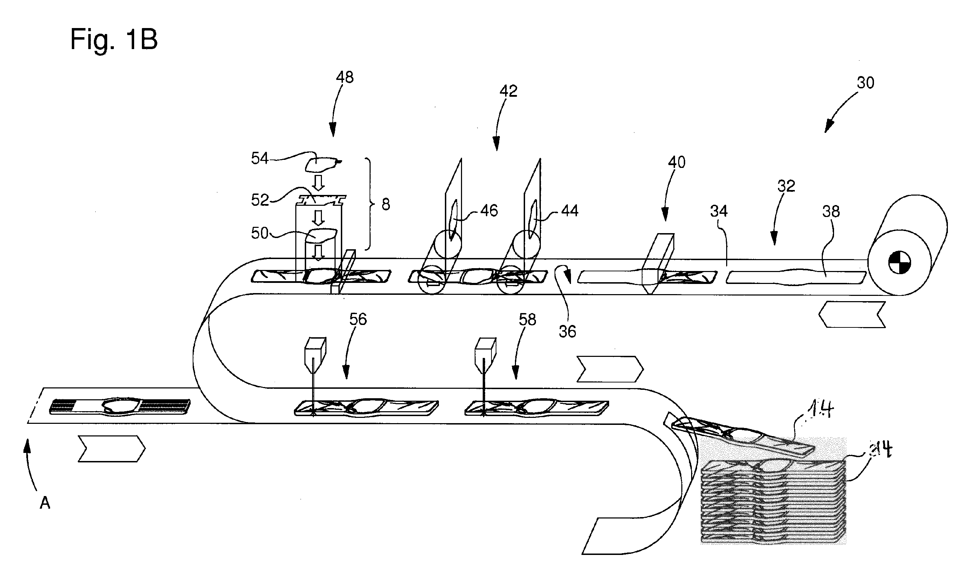

- la figure 1B est une représentation schématique de la partie de droite d'une installation pour la mise en oeuvre du procédé de l'invention, cette figure complétant la figure 1A.

La présente invention procède de l'idée générale inventive qui consiste à procurer un procédé de fabrication d'un dispositif électronique portable flexible dans lequel une première partie des opérations d'assemblage est effectuée sur une première bande flexible imperméable, tandis qu'une seconde partie des opérations d'assemblage est effectuée sur une seconde bande flexible imperméable, les première et seconde bandes flexibles imperméables étant assemblées lors d'une dernière étape de fabrication, puis débitées pour libérer les dispositifs électroniques portables un à un.

La figure 1A est une représentation schématique de la partie de gauche d'une installation pour la mise en oeuvre du procédé de l'invention, tandis que la figure 1B est une représentation schématique de la partie de droite de l'installation de mise en oeuvre du procédé de l'invention, la réunion des figures 1A et 1B illustrant l'installation de production dans sa totalité. On notera que la partie de gauche de l'installation illustrée à la figure 1A se raccorde à la partie de droite de l'installation illustrée à la figure 1B dans une zone marquée d'une flèche A sur la figure 1B.

Désignée dans son ensemble par la référence numérique générale 1, la partie de gauche de l'installation de mise en oeuvre du procédé de fabrication selon l'invention comprend un poste de formage à chaud 2 devant lequel on fait défiler de la gauche vers la droite du dessin une première bande plastique imperméable 4 pour ménager de place en place dans la première bande plastique imperméable 4 une pluralité de logements 6 destinés à recevoir chacun ultérieurement au moins un composant interne au dispositif électronique portable flexible 14 tel qu'un ensemble électronique 8 d'élaboration d'une information. Cette technique consiste à presser à chaud la première bande plastique imperméable 4 dans un premier moule 10 comprenant deux empreintes 12 et 13 qui présentent des formes complémentaires correspondant au profil que l'on veut donner à la bande plastique imperméable 4. On notera que cette opération est facultative et ne dépend que de la finesse de la forme à répliquer. Le cas échéant, cette opération peut être réalisée en même temps que l'opération de moulage décrite ci-dessous.

Après formage à chaud et refroidissement consécutif, la première bande plastique imperméable 4 est surmoulée avec une matière plastique souple, par exemple un élastomère, qui donnera aux dispositifs électroniques portables 14 résultants une épaisseur et un volume rendant le dispositif électronique 14 agréable à porter. Cette technique est couramment désignée par sa dénomination anglo-saxonne Film Insert Moulding. A cet effet, on fait défiler la première bande plastique imperméable 4 devant un poste de surmoulage 16. Ce poste de surmoulage 16 comprend un second moule 18 avec une partie supérieure 20 identique à l'empreinte 12 du premier moule 10 et une partie inférieure 22. La partie supérieure 20 du second moule 18 contre laquelle la première bande plastique imperméable 4 est plaquée présente un profil qui épouse celui de la première bande plastique imperméable 4, et la partie inférieure 22 présente des épargnes 24 aux endroits où l'on veut injecter la matière plastique dans laquelle doit être réalisé le corps 26 des dispositifs électroniques portables 14.

A l'issue des étapes de fabrication décrites ci-dessus, on a formé dans la première bande plastique imperméable 4 une pluralité de corps 26 en matière plastique qui sont encore d'un seul tenant avec la première bande plastique imperméable 4 et qui présentent sensiblement la forme d'une bande ou d'un bracelet. Le procédé de fabrication peut être complété par une étape d'insertion d'éléments de fermeture 28 du bracelet tels que des aimants.

Désignée dans son ensemble par la référence numérique générale 30, la partie de droite de l'installation de mise en oeuvre du procédé de fabrication selon l'invention comprend un poste de transfert à chaud 32 devant lequel on fait défiler de la droite vers la gauche du dessin une seconde bande plastique imperméable 34 qui reçoit, de place en place, sur une face inférieure 36 une couche 38 de matériau apte à absorber un rayonnement laser.

La seconde bande plastique imperméable 34 passe ensuite dans un poste d'impression 40 dans lequel la seconde bande plastique imperméable 34 reçoit sur la face inférieure 36 au moins une encre décorative.

La seconde bande plastique imperméable 34 passe aussi devant un poste de laminage 42 dans lequel un film adhésif 44 et un dispositif d'affichage souple 46 tel qu'une cellule d'affichage à cristal liquide sont successivement laminés sur la face inférieure 36 de la seconde bande plastique imperméable 34. Le film adhésif 44 permet la solidarisation du dispositif d'affichage souple 46 sur la face inférieure 36 de la seconde bande plastique imperméable 34.

La seconde bande plastique imperméable 34 passe enfin dans un poste d'assemblage 48 dans lequel la seconde bande plastique imperméable 34 reçoit, de place en place, sur la face inférieure 36, les ensembles électroniques 8 d'élaboration d'une information. Dans l'exemple représenté au dessin, les dispositifs électroniques portables 14 sont prévus pour élaborer en particulier une information horaire. A cet effet, chaque ensemble électronique 8 comprend, outre le dispositif d'affichage souple 46, un guide de lumière 50 disposé sous le dispositif d'affichage souple 46 et prévu pour éclairer ce dernier par l'arrière. Le montage est complété par un circuit imprimé flexible 52 sur lequel sont montés les divers composants électroniques intégrés et discrets (non visibles au dessin) nécessaires au bon fonctionnement du dispositif électronique portable 14 tels que, notamment, une base de temps. L'ensemble électronique 8 est alimenté au moyen d'une batterie souple 54.

Le procédé comprend enfin l'étape consistant à réunir et à solidariser la première bande plastique imperméable 4 surmoulée avec la seconde bande plastique imperméable 34 décorée, puis à libérer les dispositifs électroniques portables flexibles 14 par découpe.

La fabrication du dispositif électronique portable 14 selon l'invention s'achève lorsqu'on solidarise la seconde bande plastique imperméable 34 sur la première bande plastique imperméable 4. A cet effet, on fait converger les première et seconde bandes plastiques imperméables 4 et 34 dans un poste de soudage laser 56 dans lequel la seconde bande plastique imperméable 34 est solidarisée sur un périmètre de la première bande plastique imperméable 4. Les deux bandes plastiques imperméables 4 et 34 ainsi réunies passent finalement dans un poste de découpe laser 58 dans lequel les dispositifs électroniques portables flexibles 14 sont individualisés.

Il va de soi que la présente invention n'est pas limitée au mode de mise en oeuvre du procédé de fabrication selon l'invention qui vient d'être décrit et que diverses modifications et variantes simples pourront être envisagées par l'homme du métier sans sortir du cadre de l'invention tel que défini par les revendications annexées.

## Revendications

1. Procédé de fabrication en série d'un dispositif électronique portable flexible (14) capable au moins d'élaborer une information, ce dispositif électronique portable (14) comprenant un ensemble électronique (8) d'élaboration d'une information, le procédé comprenant les étapes consistant à faire défiler une première bande plastique imperméable (4) devant un poste de surmoulage (16) dans lequel la première bande plastique imperméable (4) est surmoulée au moyen d'un matériau plastique qui donnera aux dispositifs électroniques portables flexibles (14) résultants une épaisseur et une résistance mécanique,
le procédé comprenant en outre les étapes consistant à faire défiler une seconde bande plastique imperméable (34) avec une face inférieure (36) tournée vers le haut, successivement :
- devant un poste d'impression (40) dans lequel la seconde bande plastique imperméable (34) reçoit sur la face inférieure (36) au moins une encre décorative ;
- devant un poste d'assemblage (48) dans lequel la seconde bande plastique imperméable (34) reçoit, de place en place, sur la face inférieure (36) les ensembles électroniques (8) d'élaboration d'une information,
le procédé comprenant en outre l'étape consistant à réunir et à souder la première bande plastique imperméable (4) surmoulée avec la seconde bande plastique imperméable (34) décorée, puis à libérer les dispositifs électroniques portables (14) par découpe.

2. Procédé de fabrication selon la revendication 1, **caractérisé en ce qu'**avant l'étape initiale de surmoulage de la première bande plastique imperméable (4), on fait défiler la première bande plastique imperméable (4) devant un poste de formage à chaud (2) pour ménager de place en place dans la première bande plastique imperméable (4) une pluralité de logements (6) destinés à recevoir chacun ultérieurement au moins un composant interne au dispositif électronique portable flexible.

## Patentansprüche

1. Verfahren zum Herstellen in Serie einer flexiblen, tragbaren elektronischen Vorrichtung (14), die wenigstens eine Information bearbeiten kann, wobei diese tragbare elektronische Vorrichtung (14) eine elektronische Anordnung (8) zum Bearbeiten einer Information umfasst, wobei das Verfahren die Schritte umfasst, die darin bestehen, ein undurchlässiges erstes Kunststoffband (4) vor einer Übergießstation (16) vorbei zu bewegen, in der das undurchlässige erste Kunststoffband (4) mittels eines Kunststoffs übergossen wird, der den resultierenden flexiblen, tragbaren elektronischen Vorrichtungen (14) eine Dicke und einen mechanischen Widerstand verleiht,
wobei das Verfahren außerdem die Schritte umfasst, die darin bestehen, ein undurchlässiges zweites Kunststoffband (34) mit einer nach oben gewendeten untere Fläche nacheinander vor Folgendem vorbei zu bewegen:
- vor einer Druckstation (40), in der das undurchlässige zweite Kunststoffband (34) auf der unteren Fläche (36) wenigstens eine dekorative Tinte aufnimmt; und
- vor einer Montagestation (48), in der das undurchlässige zweite Kunststoffband (34) auf der unteren Fläche (36) stellenweise die elektronischen Anordnungen (8) zum Bearbeiten einer Information aufnimmt;
wobei das Verfahren außerdem den Schritt umfasst, der darin besteht, das übergossene undurchlässige erste Kunststoffband (4) mit dem dekorierten undurchlässigen zweiten Kunststoffband (34) zu vereinigen und zu schweißen dann die tragbaren elektronischen Vorrichtungen (14) durch Ausschneiden freizugeben.

2. Herstellungsverfahren nach Anspruch 1, **dadurch gekennzeichnet, dass** vor dem anfänglichen Schritt des Übergießens des undurchlässigen ersten Kunststoffbandes (4) das undurchlässige erste Kunststoffband (4) vor einer Heißformungsstation (2) vorbei bewegt wird, um in dem undurchlässigen ersten Kunststoffband (4) stellenweise mehrere Aufnahmesitze (6) auszubilden, die dazu bestimmt sind, später jeweils wenigstens eine interne Komponente der flexiblen, tragbaren elektronischen Vorrichtung aufzunehmen.

## Claims

1. Method of mass producing a flexible portable electronic device (14) capable of at least processing information, said portable electronic device (14) including an electronic assembly (8) for processing information, the method including the steps consisting in passing a first impermeable plastic strip (4) through an overmoulding station (16) in which the first impermeable plastic strip (4) is overmoulded using a flexible plastic material which will give the resulting flexible portable electronic devices (14) a thickness and a mechanical resistance,
the method further including the steps consisting in passing a second impermeable plastic strip (34) with a bottom surface (36) facing upwards, in succession:
- through a printing station (40) in which the second impermeable plastic strip (34) receives, on the bottom surface (36) thereof, at least one decorative ink;
- through an assembly station (48) in which the second impermeable plastic strip (34) receives, in various places on the bottom surface (36) thereof, the electronic assemblies (8) for processing information,
the method further including the step consisting in joining and welding the first overmoulded impermeable plastic strip (4) to the second decorated impermeable plastic strip (34), and then in cutting out and releasing the portable electronic devices (14).

2. Manufacturing method according to claim 1, **characterized in that**, before the initial step of overmoulding the first impermeable plastic strip (4), the first impermeable plastic strip (4) is passed through a thermoforming station (2) for arranging, at various places in the first impermeable plastic strip (4), a plurality of housings (6) each intended to subsequently receive at least one internal component of the flexible portable electronic device.
